# FASCICULE DE BREVET EUROPEEN

(11) **EP 4 117 038 B1**
(45) Date de publication et mention de la délivrance du brevet: **24.04.2024**
(21) Numéro de dépôt: 22182994.8
(22) Date de dépôt: 05.07.2022
(51) Int. Cl.: H10B 63/00

(54) **CIRCUIT MÉMOIRE COMPRENANT UNE PLURALITÉ DE CELLULES MÉMOIRE 1T1R**
SPEICHERSCHALTKREIS MIT EINER VIELZAHL VON 1T1R-SPEICHERZELLEN
MEMORY CIRCUIT COMPRISING A PLURALITY OF 1T1R MEMORY CELLS

(30) Priorité: 08.07.2021 FR 2107409
(43) Date de publication de la demande: 11.01.2023
(73) Titulaire: Commissariat à l'Energie Atomique et aux Energies Alternatives, 75015 Paris (FR)
(72) Inventeur: BILLOINT, Olivier, 38054 Grenoble Cedex 09 (FR); CAGLI, Carlo, 38054 Grenoble Cedex 09 (FR); GRENOUILLET, Laurent, 38054 Grenoble Cedex 09 (FR)
(74) Mandataire: Cabinet Camus Lebkiri

(56) Documents cités:
- US-A1- 2017 179 196
- US-A1- 2018 269 209
- US-A1- 2019 252 375

## Description

### DOMAINE TECHNIQUE

La présente invention est relative au domaine des mémoires résistives à accès aléatoire RRAM (pour « Résistive Random Access Memories » en anglais). L'invention concerne plus particulièrement un dispositif mémoire de type 1T1R comprenant un élément mémoire résistif et un transistor de sélection connecté en série avec l'élément mémoire résistif. L'invention concerne également un circuit mémoire comprenant une pluralité de cellules mémoire 1T1R agencées sous la forme d'une matrice.

### ÉTAT DE LA TECHNIQUE

Les mémoires résistives, en particulier les mémoires résistives à base d'oxyde (OxRAM, pour « Oxide-based Random Access Memories »), sont des mémoires non-volatiles ayant pour but de remplacer les mémoires de type Flash. En plus d'une forte densité d'intégration, elles présentent une vitesse de fonctionnement élevée, une grande endurance et une bonne compatibilité avec les procédés de fabrication utilisés actuellement dans l'industrie microélectronique, en particulier avec le procédé de fin de ligne (BEOL, pour « Back-End Of Line » en anglais) de la technologie CMOS.

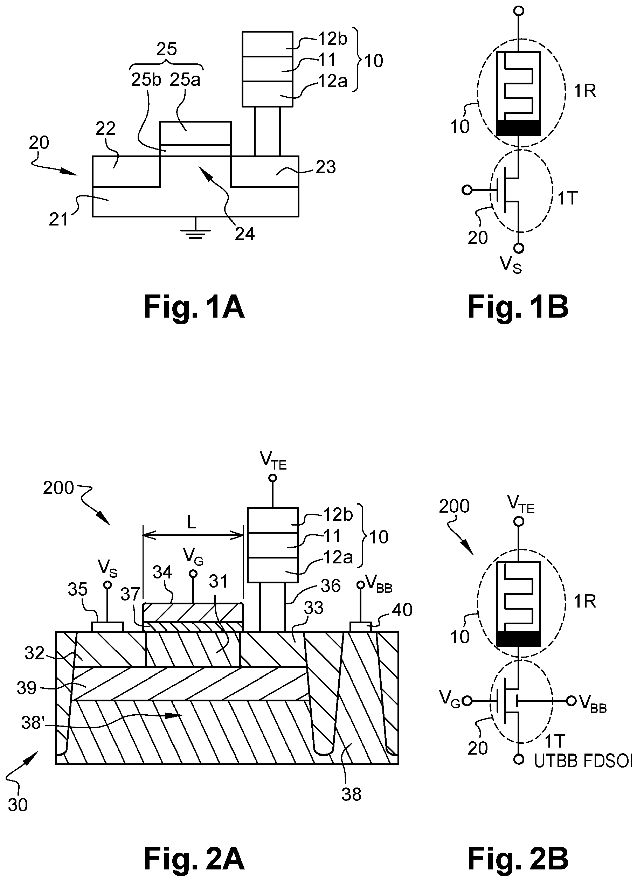

Les mémoires résistives comprennent une multitude de cellules mémoire agencées sous la forme d'une matrice. Dans une configuration dite « 1 T1 R » représentée par les figures 1A-1B, chaque cellule mémoire (appelée également point mémoire) comprend un élément mémoire résistif 10 (« 1R») et un transistor de sélection 20 (« 1T ») connecté en série avec l'élément mémoire résistif 10. L'élément mémoire résistif 10 est constitué d'un empilement M-I-M (Métal-Isolant-Métal) comprenant une couche de matériau actif à résistance électrique variable 11 disposée entre deux électrodes métalliques 12a-12b. Dans un élément de type OxRAM, le matériau actif est généralement un oxyde de métal de transition (ex. HfO₂, Ta₂O₅, TiO₂...).

L'élément mémoire résistif 10 peut commuter de manière réversible entre deux états de résistance, qui correspondent à des valeurs logiques « 0 » et « 1 » utilisées pour coder un bit d'information. Dans certains cas, plus de deux états de résistance peuvent être générés, ce qui permet de stocker plusieurs bits d'information dans une même cellule mémoire.

L'information est écrite dans la cellule mémoire en basculant l'élément mémoire résistif 10 d'un état fortement résistif (ou « HRS », pour « High Résistance State » en anglais) à un état faiblement résistif (« LRS », pour « Low Résistance State »). À l'inverse, pour effacer l'information de la cellule mémoire, l'élément mémoire résistif 10 est basculé de l'état faiblement résistif vers l'état fortement résistif.

Dans les mémoires résistives de type filamentaire telles que les OxRAM ou les mémoires à pont conducteur (CBRAM, pour « Conductive-Bridge Random-Access Memory » en anglais), le changement de résistance de l'élément mémoire est gouverné par la formation et la rupture d'un filament conducteur de section nanométrique entre les deux électrodes.

Immédiatement après sa fabrication, un élément mémoire de type OxRAM est dans un état vierge caractérisé par une résistance (dite initiale) très élevée, bien supérieure à la résistance de l'élément mémoire lorsqu'il est dans l'état fortement résistif. La couche d'oxyde est en effet isolante dans son état initial. Pour que l'élément mémoire puisse être utilisé, il est nécessaire d'accomplir une étape d'initialisation dite de « forming ». Cette étape consiste en un claquage partiellement réversible de l'oxyde afin de générer pour la première fois le filament conducteur (et donc placer l'élément mémoire dans l'état faiblement résistif). Après ce claquage, la couche d'oxyde initialement isolante devient active et l'élément mémoire peut commuter entre l'état faiblement résistif et l'état fortement résistif par des opérations d'effacement et d'écriture.

L'étape de forming est accomplie en appliquant entre les deux électrodes de l'élément mémoire une tension (dite de « forming ») de valeur bien supérieure à la tension nominale de fonctionnement de l'élément mémoire (utilisée lors des cycles d'écriture-effacement suivants), par exemple une tension de l'ordre de 2,5 V pour une tension nominale de l'ordre de 1,5 V.

Le transistor de sélection 20 sert notamment à polariser l'élément mémoire résistif 10 de manière à initialiser, programmer ou lire la cellule mémoire. Il peut jouer également le rôle de limiteur de courant. En effet, il est nécessaire de limiter le courant électrique qui traverse l'élément mémoire résistif 10 pour ne pas le dégrader lors de l'étape d'initialisation et pour contrôler la taille du filament (obtenu après une opération d'écriture), dont dépend les propriétés de l'élément mémoire (dispersion des états de résistance, fenêtre mémoire, endurance, tenue en température...).

Le transistor de sélection 20 peut être un transistor à effet de champ Métal-Oxyde-Semiconducteur (MOSFET) formé dans un substrat en silicium massif 21 (substrat « bulk »). Le transistor de sélection 20 comprend alors une région de source 22, une région de drain 23 et une région de canal 24 disposée entre la région de source 22 et la région de drain 23. La région de canal 24 est surmontée d'une structure de grille 25 comprenant une électrode de grille 25a et un diélectrique de grille 25b.

Le document [« OxRAM for embedded solutions on advanced node: scaling perspectives considering statistical reliability and design constraints", J. Sandrini et al., 2019 IEEE International Electron Devices Meeting (IEDM), p. 30.5.1-30.5.4, 2019] décrit une autre cellule mémoire 1T1R comprenant un élément mémoire résistif de type OxRAM et un transistor de sélection en technologie silicium sur isolant complètement dépiété (ou FDSOI, pour « Fully Depleted Silicon On Insulator »). Dans ce document, il est montré que les besoins de l'élément OxRAM en termes de courant de programmation et de tension de forming peuvent être satisfaits par un transistor FDSOI. Le document FR3045938concerne un circuit intégré, comprenant : -un transistor à effet de champ, comprenant : -des première et deuxième électrodes de conduction ; -une zone de canal disposée entre les première et deuxième électrodes de conduction ; -un empilement de grille disposé à l'aplomb de la zone de canal, et comprenant une électrode de grille ; -un point mémoire de type RRAM ménagé sous la zone de canal, ou ménagé dans l'empilement de grille sous l'électrode de grille.

La taille d'une cellule mémoire 1T1R est principalement dictée par la surface du substrat (silicium massif ou SOI) occupée par le transistor de sélection, plutôt que par les dimensions de l'élément mémoire. Cela est dû aux besoins en courant et en tension de l'élément mémoire (qui doivent être satisfaits par le transistor de sélection) et au fait que l'élément mémoire est formé dans la partie dite « back-end » du circuit, autrement dit dans les niveaux d'interconnexion disposés sur le substrat.

Pour augmenter la densité des mémoires résistives, il est donc nécessaire de réduire la surface occupée par le transistor de sélection de chaque cellule mémoire. Cette réduction s'effectue au détriment du courant que le transistor de sélection est capable de délivrer. Or les performances de l'élément mémoire comme la fenêtre mémoire se dégradent pour des courants de programmation inférieurs à 100 µA.

### RÉSUMÉ DE L'INVENTION

Il existe donc un besoin de réduire la surface occupée par le transistor de sélection dans une cellule mémoire 1T1R sans toutefois diminuer les performances de l'élément mémoire résistif auquel il est connecté.

Selon un premier aspect de l'invention, on tend à satisfaire ce besoin en prévoyant un dispositif mémoire comprenant un élément mémoire résistif et un transistor de sélection de type FDSOI connecté en série avec l'élément mémoire résistif, le transistor de sélection comprenant une région de canal, une couche isolante enterrée et une grille arrière séparée de la région de canal par la couche isolante enterrée, le dispositif mémoire comprenant en outre un circuit de polarisation de la grille arrière du transistor de sélection, le circuit de polarisation étant configuré pour appliquer une polarisation arrière directe (ou FBB, pour « Forward Back-Bias » en anglais) au transistor de sélection lors d'une opération de programmation ou d'initialisation de l'élément mémoire résistif.

Un transistor FDSOI à grille arrière, aussi appelé à corps et oxyde enterré ultraminces ou UTBB (pour « Ultra Thin Body and BOX » en anglais), est capable de fournir le même courant qu'un transistor MOS sur substrat massif (ou qu'un transistor FDSOI à oxyde enterrée épais), tout en occupant une surface plus faible. En effet, en appliquant une polarisation en face arrière du transistor (technique appelée « back-biasing » en anglais), il est possible de moduler dynamiquement la tension de seuil du transistor et donc sa capacité à fournir du courant. Le courant délivré par le transistor de sélection UTBB FDSOI peut ainsi être augmenté ponctuellement, typiquement lors des opérations de programmation ou lors d'une opération d'initialisation (étape dite de « forming »).

Dans un mode de réalisation préférentiel du dispositif mémoire, le circuit de polarisation est en outre configuré pour appliquer une polarisation arrière inverse (ou RBB, pour « Reverse Back-Bias » en anglais) au transistor de sélection lors d'une opération de lecture de l'élément mémoire résistif. La consommation électrique du dispositif mémoire est ainsi réduite.

Avantageusement, le circuit de polarisation est en outre configuré pour appliquer une polarisation arrière inverse au transistor de sélection en dehors des opérations de programmation, d'initialisation et de lecture de l'élément mémoire résistif.

De préférence, l'élément mémoire résistif est de type OxRAM, CBRAM ou PCRAM.

Un deuxième aspect de l'invention concerne un circuit mémoire comprenant une pluralité de cellules mémoire, chaque cellule mémoire comprenant un élément mémoire résistif et un transistor de sélection de type FDSOI connecté en série avec l'élément mémoire résistif, le transistor de sélection comprenant une région de canal, une couche isolante enterrée et une grille arrière séparée de la région de canal par la couche isolante enterrée. Le circuit mémoire comprend en outre un circuit de polarisation de la grille arrière des transistors de sélection, le circuit de polarisation étant configuré pour appliquer une polarisation arrière directe au transistor de sélection d'au moins une cellule mémoire lors d'une opération de programmation ou d'initialisation de ladite au moins une cellule mémoire.

Avantageusement, le circuit de polarisation est en outre configuré pour appliquer une polarisation arrière inverse au transistor de sélection de ladite au moins une cellule mémoire lors d'une opération de lecture de ladite au moins une cellule mémoire.

Avantageusement, le circuit de polarisation est en outre configuré pour, lors d'une opération de lecture d'une cellule mémoire, appliquer une polarisation arrière inverse au transistor de sélection de plusieurs cellules mémoire adjacentes à la cellule mémoire lue.

De préférence, les transistors de sélection des cellules mémoire sont agencés en lignes et en colonnes, les lignes de transistors forment plusieurs groupes de transistors, chaque groupe de transistors comprenant au moins deux lignes de transistors consécutives, et le circuit mémoire comprend des régions distinctes de silicium dopé appelées caissons, chaque caisson comprenant les grilles arrière des transistors de sélection appartenant à un seul et même groupe de transistors.

Dans un premier mode de réalisation du circuit mémoire, les caissons sont dopés d'un même type de conductivité et espacés les uns des autres. Les transistors de sélection peuvent être tous de type NMOS soit tous de type PMOS.

Dans un deuxième mode de réalisation, le circuit mémoire comprend des caissons dopés d'un premier type de conductivité et au moins un caisson dopé d'un deuxième type de conductivité opposé, les caissons dopés du premier type de conductivité et ledit au moins un caisson dopé du deuxième type de conductivité étant disposés en alternance. Les caissons dopés du premier type de conductivité et ledit au moins un caisson dopé du deuxième type de conductivité peuvent être adjacents ou séparés par des tranchées d'isolation électrique. De préférence, tous les transistors de sélection d'un groupe associé à un caisson dopé de type N sont de type NMOS et tous les transistors de sélection d'un groupe associé à un caisson dopé de type P sont de type PMOS.

Avantageusement, chaque groupe de transistors comprend entre 16 et 256 lignes de transistors consécutives.

Chaque groupe de transistors peut comprendre une ou plusieurs paires de lignes de transistors consécutives et, pour chaque paire, les transistors de sélection appartenant à une même colonne peuvent partager une même région choisie parmi la région de source et la région de drain.

Dans un mode de réalisation particulier, le circuit de polarisation est configuré pour appliquer un potentiel de polarisation arrière directe à un premier caisson lors d'une opération de programmation ou d'initialisation d'une ou plusieurs cellules mémoire appartenant au groupe associé au premier caisson.

Selon un développement de ce mode de réalisation, le circuit de polarisation est en outre configuré pour appliquer un potentiel de polarisation arrière inverse à au moins un deuxième caisson distinct du premier caisson.

Un troisième aspect de l'invention concerne un procédé de fonctionnement d'un circuit mémoire comprenant une pluralité de cellules mémoire, chaque cellule mémoire comprenant un élément mémoire résistif et un transistor de sélection de type FDSOI connecté en série avec l'élément mémoire résistif, le transistor de sélection comprenant une région de canal, une couche isolante enterrée, une grille arrière séparée de la région de canal par la couche isolante enterrée. Le procédé comprend une opération de programmation ou d'initialisation d'au moins une cellule mémoire, lors de laquelle une polarisation arrière directe est appliquée au transistor de sélection de ladite au moins une cellule mémoire.

De préférence, le procédé comprend en outre une opération de lecture de ladite au moins cellule mémoire, lors de laquelle une polarisation arrière inverse est appliquée au transistor de sélection de ladite au moins une cellule mémoire.

Avantageusement, le procédé comprend en outre l'application d'une polarisation arrière inverse aux transistors de sélection des cellules mémoire en dehors des opérations de programmation, d'initialisation et de lecture des cellules mémoire.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes.

La figure 1A est une vue en coupe schématique d'une cellule mémoire 1T1R selon l'art antérieur.

La figure 1B est un schéma électrique équivalent de la cellule mémoire 1T1R de la figure 1A.

La figure 2A est une vue en coupe schématique d'une cellule mémoire 1T1R appartenant à un dispositif mémoire selon un premier aspect de l'invention.

La figure 2B est un schéma électrique équivalent de la cellule mémoire 1T1R de la figure 2A.

La figure 3 représente schématiquement un circuit mémoire comprenant plusieurs cellules mémoire 1T1R agencées en lignes et en colonnes, selon un deuxième aspect de l'invention.

La figure 4 représente l'agencement des transistors de sélection dans un premier mode de réalisation du circuit mémoire.

La figure 5 représente l'agencement des transistors de sélection dans un deuxième mode de réalisation du circuit mémoire.

La figure 6A est une vue en coupe partielle du circuit mémoire selon le plan de coupe A-A des figures 4 et 5.

La figure 6B est une vue en coupe partielle du circuit mémoire selon le plan de coupe B-B de la figure 5.

La figure 7 est un graphique représentant l'augmentation de surface causée par la répartition des lignes de transistors en groupes, en fonction du nombre de lignes de transistors par groupe.

La figure 8 est un graphique représentant la diminution des courants de fuite du circuit mémoire lors de la lecture d'une cellule mémoire, en fonction du nombre de lignes de transistors par groupe.

Pour plus de clarté, les éléments identiques ou similaires sont repérés par des signes de référence identiques sur l'ensemble des figures.

### DESCRIPTION DÉTAILLÉE

Les figures 2A-2B représentent schématiquement une cellule mémoire 200 de type 1T1R appartenant à un dispositif mémoire selon l'invention.

La cellule mémoire 200 comprend un élément mémoire résistif 10 et un transistor de sélection 30 connecté électriquement en série avec l'élément mémoire résistif 10.

L'élément mémoire résistif 10 est capable de basculer de manière réversible entre deux états de résistance : un état fortement résistif (HRS), appelé également état « OFF », et un état faiblement résistif (LRS) ou état « ON ». Il comprend une couche de matériau à résistance électrique variable 11, aussi appelé matériau résistif, disposée entre deux électrodes :
- une première électrode 12a appelée électrode inférieure, sur laquelle est disposée la couche de matériau résistif 11 ; et
- une deuxième électrode 12b appelée électrode supérieure et disposée sur la couche de matériau résistif 11.

L'élément mémoire résistif 10 est de préférence un élément mémoire de type filamentaire, autrement dit un élément mémoire dont le changement d'état de résistance est gouverné par la formation et la rupture d'un filament conducteur entre les deux électrodes 12a-12b.

L'élément mémoire résistif 10 est avantageusement un élément mémoire de type « OxRAM ». Le matériau résistif est alors un oxyde, par exemple un oxyde de métal de transition (ex. HfO₂, Ta₂O₅, TiO₂...) ou un oxyde de silicium (SiOₓ). Les électrodes 12a-12b peuvent être formées de silicium dopé, d'un siliciure, d'un métal (ex. titane, tantale, tungstène...) ou d'un matériau à caractère métallique, tel que le nitrure de titane (TiN) ou le nitrure de tantale (TaN).

Alternativement, l'élément mémoire résistif 10 peut être un élément mémoire de type « CBRAM ». Le matériau résistif est alors un matériau conducteur ionique et électriquement isolant. L'une des électrodes (la cathode) est en un matériau inerte et l'autre électrode (l'anode) est en un matériau soluble.

L'élément mémoire résistif 10 peut également être un élément mémoire de type « PCRAM ». Dans ce cas, les électrodes sont constituées de matériaux inertes et le matériau résistif est un matériau à changement de phase, typiquement un chalcogénure. L'état logique de l'élément mémoire est alors lié à la phase du matériau résistif (typiquement état « ON » pour une phase cristalline et état « OFF » pour la phase amorphe).

La cellule mémoire 200 peut être soumise à des opérations de programmation, à des opérations de lecture et à une opération d'initialisation appelée communément « forming » (et dont le mécanisme dépend du type d'élément mémoire). Les opérations de programmation consistent à faire basculer l'élément mémoire résistif 10 de manière réversible entre l'état fortement résistif (HRS) et l'état faiblement résistif (LRS). Lorsque l'élément mémoire résistif 10 passe de l'état fortement résistif à l'état faiblement résistif, l'opération de programmation correspondante est appelée écriture ou « set ». Inversement, lorsque l'élément mémoire résistif 10 passe de l'état faiblement résistif à l'état fortement résistif, l'opération de programmation correspondante est appelée effacement ou « reset ». Une opération de programmation peut donc être soit une opération d'écriture, soit une opération d'effacement. L'opération de lecture permet de déterminer dans quel état de résistance est l'élément mémoire résistif 10. Enfin, l'opération d'initialisation permet, dans le cas d'une CBRAM ou d'une OxRAM, de former pour la première fois le filament conducteur.

Le transistor de sélection 30 sert à polariser l'élément mémoire résistif 10 de façon à initialiser, programmer ou lire la cellule mémoire 200. Il peut jouer également le rôle de limiteur de courant lors de l'opération d'initialisation et des opérations de programmation, afin de ne pas dégrader l'élément mémoire résistif 10. Grâce au transistor de sélection 30, le courant électrique parcourant l'élément mémoire résistif 10 ne peut dépasser une valeur seuil appelée courant de compliance. Le courant de compliance d'une cellule de mémoire résistive (RRAM) est typiquement compris entre 50 µA et 400 µA. Il est défini en fonction du type, des dimensions et des critères de performance (tels que la fenêtre mémoire, l'endurance...) de l'élément mémoire résistif 10.

Le transistor de sélection 30 est un transistor MOS de type FDSOI à grille arrière, aussi appelé transistor à corps et oxyde enterré ultraminces ou UTBB (pour « Ultra Thin Body and BOX » en anglais). Ce type de transistor MOS est fabriqué à partir d'un substrat SOI comprenant successivement une couche de support en silicium, une couche électriquement isolante dite enterrée, généralement une couche d'oxyde (ou couche BOX, pour « buried oxide layer » en anglais), et un film mince en silicium monocristallin, aussi appelé couche active. La particularité du transistor UTBB FDSOI est que la couche isolante enterrée est extrêmement mince, typiquement d'épaisseur inférieure à 30 nm, ce qui permet d'appliquer une polarisation en face arrière du transistor. L'épaisseur du film mince en silicium monocristallin est typiquement inférieure à 10 nm.

Le transistor de sélection 30 comprend ainsi une région de canal 31, une région de source 32 et une région de drain 33, toutes les trois formées dans le film mince de silicium du substrat SOI. La région de canal 31 est disposée entre la région de source 32 et la région de drain 33. Le film mince de silicium est surmonté d'une électrode de grille 34, d'une électrode de source 35 en contact avec la région de source 32 et d'un plot de contact 36 en contact avec la région de drain 33. L'électrode de grille 34 est séparée de la région de canal 31 par un diélectrique de grille 37. Le plot de contact 36 relie électriquement la région de drain 33 du transistor de sélection 30 à l'électrode inférieure 12a de l'élément mémoire résistif 10.

Le transistor de sélection 30 peut être un transistor NMOS (régions de source et de drain 32-33 dopées de type N) ou PMOS (régions de source et de drain 32-33 dopées de type P). La région de canal 31 est de préférence non intentionnellement dopée.

Le transistor de sélection 30 comprend en outre une région de silicium dopé 38 appelée caisson (« well »), dont une partie 38' appelée plan de masse (« ground plane ») ou grille arrière (« back gate ») est située sous la couche d'oxyde enterrée 39 du substrat SOI. Le caisson 38 est formé en implantant des impuretés dopantes dans la couche de support en silicium (non représentée) du substrat SOI. La grille arrière 38' peut présenter une concentration en impuretés dopantes plus élevée que la partie restante du caisson 38.

Le caisson 38 peut être dopé de type N ou de type P. Toutefois, dans un mode de réalisation du dispositif mémoire, le caisson 38 du transistor de sélection 30 est dopé de type N dans le cas d'un NMOS et de type P dans le cas d'un PMOS, afin d'obtenir un transistor à faible tension de seuil (ou LVT, pour « Low Voltage Threshold »). Un transistor LVT est ici plus avantageux qu'un transistor à tension de seuil élevée (ou HVT, pour « High Voltage Threshold ») en raison de sa capacité à fournir davantage de courant à l'état passant à surface identique (ou sa plus petite surface à un courant donné).

La grille arrière 38' agit comme une seconde grille. En faisant varier le potentiel électrique de la grille arrière 38', séparée de la région de canal 31 par la couche isolante enterrée 39, il est possible de moduler (dynamiquement) la tension de seuil du transistor UTBB FDSOI et par conséquent sa résistance à l'état passant (R_{ON}).

Lors du fonctionnement de la cellule mémoire 200, un premier potentiel électrique V_{G} (appelé potentiel de grille) est appliqué sur l'électrode de grille 34, un deuxième potentiel électrique Vs (potentiel de source) est appliqué sur l'électrode de source 35, un troisième potentiel V_{TE} est appliqué sur l'électrode supérieure 12b de l'élément mémoire résistif 10 et un quatrième potentiel électrique V_{BB} appelé potentiel de polarisation arrière est appliqué sur la grille arrière 38' au moyen d'un contact de grille arrière 40 en contact avec le caisson 38. Chacun de ces potentiels électriques peut prendre des valeurs différentes selon le mode de fonctionnement de la cellule mémoire 200 (initialisation, écriture, effacement et lecture). Le contact de grille arrière 40 est de préférence situé au même niveau (c'est-à-dire à la même hauteur), que l'électrode de source 35 et le plot de contact 36 (soit ici sur le film mince de silicium). Pour un même caisson, il peut être prévu plusieurs contacts de grille arrière espacés régulièrement (par exemple tous les 30 µm) afin d'assurer une polarisation homogène.

Outre la cellule mémoire 200, le dispositif mémoire comporte un circuit de polarisation de la grille arrière 38', relié au contact de grille arrière 40. Ce circuit de polarisation, non illustré sur les figures, est configuré pour sélectionner et appliquer le potentiel de polarisation arrière V_{BB}.

L'opération d'initialisation et les opérations de programmation (écriture, effacement) de la cellule mémoire 200 nécessitent un courant important. Le transistor de sélection 30 doit donc laisser passer suffisamment de courant pour permettre le changement d'état de résistance de l'élément mémoire résistif.

Dans la cellule mémoire 1T1R de l'art antérieur (cf. Figs.1A-1B), le transistor de sélection 20 est dimensionné de manière à pouvoir fournir un courant supérieur ou égal au courant de compliance requis pour programmer/initialiser efficacement la cellule mémoire.

Dans le dispositif mémoire selon l'invention, le transistor de sélection 30 de la cellule mémoire 200 est au contraire dimensionné pour qu'en l'absence de polarisation arrière, le courant maximal délivré par transistor soit inférieur au courant de compliance. Une polarisation arrière directe (ou FBB, pour « Forward Back-Bias » en anglais) est appliquée au transistor de sélection 30 lors des opérations de programmation et/ou de l'opération d'initialisation de la cellule mémoire 200, pour augmenter temporairement le courant délivré par le transistor de sélection 30.

Ainsi, le transistor de sélection 30 occupe une plus petite surface (sur le substrat SOI) qu'un transistor MOS classique (sur substrat massif) ou qu'un transistor FDSOI dépourvu de grille arrière (sur substrat SOI), sans toutefois diminuer les performances de l'élément mémoire résistif 10. La taille de la cellule mémoire 200 est alors réduite. En outre, comme les dimensions du transistor de sélection 30 sont réduites, les courants de fuite du transistor de sélection 30 dans l'état bloqué sont diminués. Il en résulte une diminution de la consommation statique de la cellule mémoire 200.

La polarisation arrière directe peut être obtenue au moyen d'un potentiel de polarisation arrière positif (V_{BB} > 0) dans le cas d'un transistor NMOS et d'un potentiel de polarisation arrière négatif (V_{BB} < 0) dans le cas d'un transistor PMOS (que le caisson 38 soit dopé N ou P). De préférence, le potentiel de polarisation arrière V_{BB} est tel que le courant délivré par le transistor de sélection 30 (sous polarisation arrière directe) soit égal ou sensiblement égal (± 20 %) au courant de compliance prédéfini.

Dans un mode de réalisation préférentiel du dispositif mémoire, le circuit de polarisation est en outre configuré pour appliquer au transistor de sélection 30 une polarisation arrière inverse (ou RBB, pour « Reverse Back-Bias » en anglais) lors d'une opération de lecture de la cellule mémoire 200. Ceci a pour effet de réduire la consommation électrique de la cellule mémoire 200 sans compromettre la lecture (car la cellule mémoire requiert un courant plus faible pour être lue).

De façon avantageuse, le circuit de de polarisation est en outre configuré pour appliquer au transistor de sélection 30 une polarisation arrière inverse en dehors des opérations de programmation, d'initialisation et de lecture de la cellule mémoire 200. Ainsi, les courants de fuite du transistor de sélection 30 dans l'état bloqué et la consommation statique de la cellule mémoire 200 sont davantage diminués.

La polarisation arrière inverse peut être obtenue au moyen d'un potentiel de polarisation arrière négatif (V_{BB} < 0) dans le cas d'un transistor NMOS et d'un potentiel de polarisation arrière positif (V_{BB} > 0) dans le cas d'un transistor PMOS (que le caisson 38 soit dopé N ou P).

Ainsi, le circuit de de polarisation est capable d'appliquer des valeurs de potentiel V_{BB} de signes opposés (au moins un valeur positive et au moins une valeur négative).

Afin de sélectionner et appliquer la valeur requise du potentiel de polarisation arrière V_{BB}, le circuit de polarisation peut comprendre un multiplexeur ayant plusieurs entrées soumises à des potentiels électriques différents (par exemple, 0,9 V, -0,9 V et 0 V) et une sortie reliée au contact de grille arrière 40.

Le circuit de polarisation peut en outre être configuré pour sélectionner et appliquer le potentiel de grille V_{G}, le potentiel de source Vs et le potentiel V_{TE} de l'électrode supérieure 12b de l'élément mémoire résistif 10.

A titre d'exemple, le transistor de sélection 30 est un transistor NMOS fabriqué en technologie UTBB FDSOI 28 nm. Il comprend une électrode de grille 34 de longueur L égale à 30 nm et une zone active de largeur W égale à 197 nm. La longueur L (dite longueur de grille) est la dimension de l'électrode de grille 34 mesurée parallèlement au substrat SOI dans le plan de coupe de la figure 2A. La largeur W est la dimension de la zone active du transistor (la zone active regroupant la région de canal 31, la région de source 32 et la région de drain 33) mesurée parallèlement au substrat SOI et perpendiculairement au plan de coupe de la figure 2A. Un courant de compliance de 150 µA est atteint sous une polarisation arrière directe de +0,9 V (V_{BB} = 0,9 V). Sous une polarisation arrière indirecte à -0,9 V (V_{BB} = -0,9 V), le courant I_{OFF} du transistor dans l'état bloqué est égale à 0,07 nA.

A titre de comparaison, pour atteindre ce même courant de compliance, un transistor NMOS en technologie « bulk » doit présenter une longueur de grille L égale à 30 nm et une largeur de zone active W égale à 226 nm, ce qui représente une augmentation de surface de 13 %. Le courant I_{OFF} du transistor NMOS bulk dans l'état bloqué est mesuré à 0,83 nA.

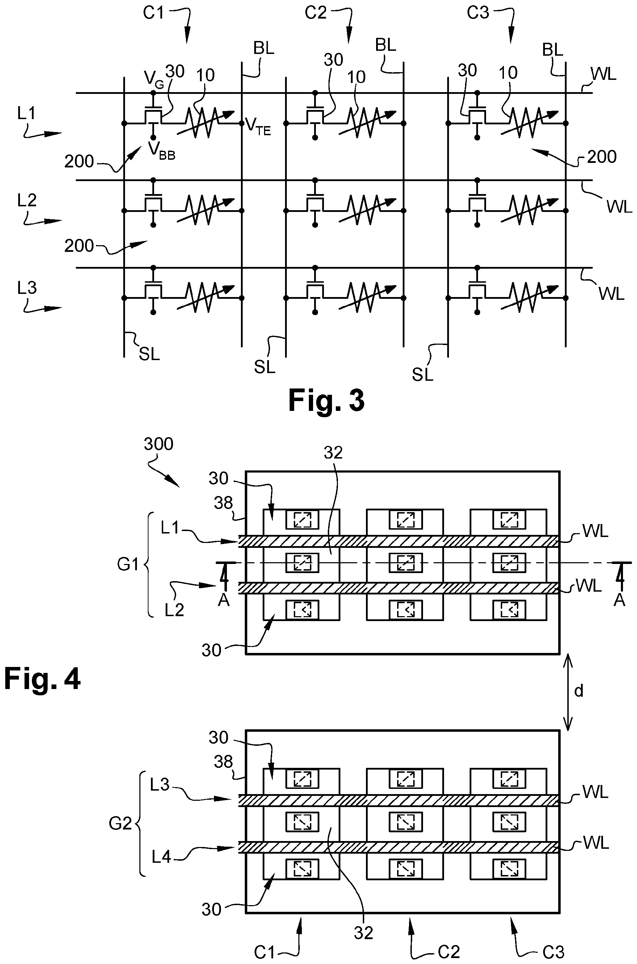

La figure 3 représente schématiquement un circuit mémoire 300 comprenant une pluralité de cellules mémoire 200, telles que décrites en relation avec les figures 2A-2B. Les transistors de sélection 30 des cellules mémoire 200 sont agencés en lignes Li et en colonnes Ci sous la forme d'une matrice. Pour ne pas alourdir inutilement la figure, seules trois lignes de transistors (L1, L2, L3) et trois colonnes de transistors (C1, C2, C3) ont été représentées. Les éléments mémoire résistifs 10 peuvent être également agencés en lignes et en colonnes. Dans ce cas, il peut être considéré que les cellules mémoire 200 sont agencées en lignes et en colonnes.

Le circuit mémoire 300 comprend en outre une pluralité de lignes de mots WL, une pluralité de lignes de source SL et une pluralité de lignes de bit BL. Chaque ligne de mot WL relie électriquement les électrodes de grille des transistors de sélection 30 appartenant à une même ligne Li de cellules mémoire 200. Chaque ligne de source SL relie électriquement les électrodes de source des transistors de sélection 30 appartenant à une même colonne Ci de cellules mémoire 200. Chaque ligne de bit BL relie électriquement les électrodes supérieures des éléments mémoire résistifs 10 appartenant à une même colonne Ci de cellules mémoire 200. Les lignes de mot WL acheminent donc le potentiel de grille V_{G}, tandis que les lignes de source SL acheminent le potentiel de source Vs et les lignes de bit BL acheminent le potentiel d'électrode supérieure V_{TE}.

Les cellules mémoire 200 peuvent être adressées individuellement ou collectivement à des fins d'initialisation, programmation ou lecture, en sélectionnant une ou plusieurs lignes de mots WL, une ou plusieurs lignes de source SL et une ou plusieurs lignes de bit BL. Les lignes de mot, de bit et de source sélectionnées sont portées aux potentiels appropriés pour initialiser, programmer ou lire la (ou les) cellule(s) mémoire adressée(s).

Outre la matrice de cellules mémoire 200, le circuit mémoire 300 comprend un circuit de polarisation (non représenté sur la figure 3) relié électriquement aux grilles arrière des transistors de sélection 30 de la matrice, afin de pouvoir sélectionner et appliquer un potentiel de polarisation arrière V_{BB} à chaque grille arrière. Ce circuit de polarisation est configuré pour appliquer une polarisation arrière directe (FBB) au transistor de sélection 30 d'une ou plusieurs cellules mémoire 200 de la matrice lors d'une opération de programmation ou d'initialisation de ces cellules mémoire 200.

Le circuit de polarisation peut en outre être configuré pour appliquer une polarisation arrière inverse (RBB) au transistor de sélection 30 d'une ou plusieurs cellules mémoires 200 lors d'une opération de lecture de ces cellules mémoire 200.

Par ailleurs, lorsqu'une cellule mémoire 200 de la matrice est adressée de manière à accomplir une opération de programmation, d'initialisation ou de lecture, une polarisation arrière inverse (RBB) est avantageusement appliquée aux transistors de sélection 30 de plusieurs cellules mémoire adjacentes à la cellule mémoire adressée, afin de diminuer les courants de fuite (courants dans l'état bloqué) de ces transistors. La consommation électrique de la matrice est ainsi diminuée. Une erreur de lecture peut être également évitée. En effet, les courants de fuite des cellules mémoire adjacentes peuvent s'additionner au courant traversant la cellule mémoire adressée et ainsi fausser la détermination de l'état de résistance de la cellule mémoire adressée. Les cellules mémoire adjacentes sont des cellules connectées à la même ligne de source SL et à la même ligne de bit BL que la cellule mémoire adressée (mais à des lignes de mot WL différentes).

De façon encore plus avantageuse, lors de la lecture d'une cellule mémoire, une polarisation arrière inverse (RBB) est avantageusement appliquée aux transistors de sélection 30 appartenant à toutes les lignes Li autres que celle à laquelle appartient la cellule mémoire lue. La consommation de puissance de la matrice mémoire est alors très fortement réduite.

Les transistors de sélection 30 appartenant à une même ligne Li peuvent partager le même caisson. Le circuit mémoire 300 comprend alors autant de caissons que de lignes Li. Une telle configuration complexifie toutefois le circuit de polarisation, multiplie les lignes de connexion des caissons et réduit drastiquement la densité d'intégration du circuit mémoire (autrement dit la densité des cellules mémoire). En effet, pour être indépendant électriquement, les caissons doivent êtres espacés d'une distance minimale dans la couche de support du substrat SOI ou isolés les uns des autres par des premières tranchées d'isolation électrique appelées tranchées d'isolation profondes (technique d'isolation DTI, pour « Deep Trench Isolation » en anglais).

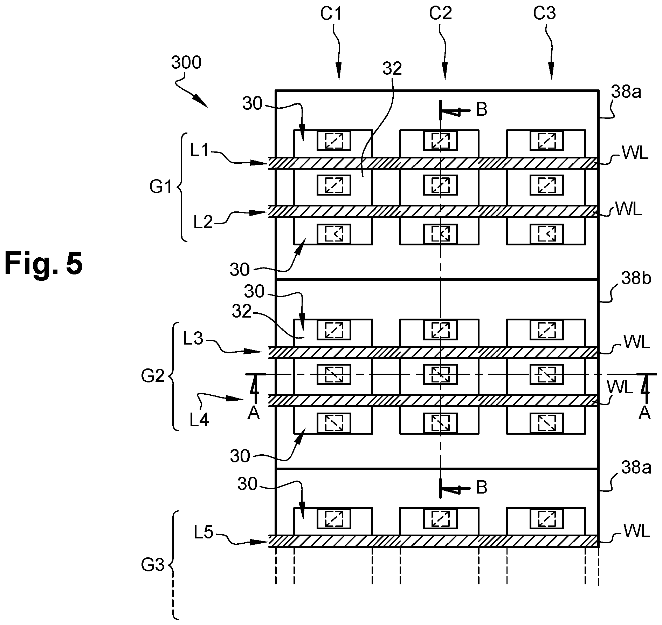

Les figures 4 et 5 représentent deux modes de réalisation du circuit mémoire 300 dans lesquels les transistors de sélection 30 sont agencés d'une manière à pouvoir leur appliquer facilement une polarisation arrière tout en augmentant la densité d'intégration du circuit mémoire 300. Les éléments mémoire résistifs des cellules mémoire ne sont pas représentés sur ces figures 4-5 (étant donné qu'ils ne limitent pas la surface de substrat occupée par les cellules mémoire). Les lignes de bit et les lignes de source ne sont pas non plus représentées.

Dans ces modes de réalisation du circuit mémoire 300, les lignes Li de transistors sont réparties en plusieurs groupes Gi de transistors, chaque groupe Gi comprenant au moins deux lignes Li consécutives. En outre, à chaque groupe Gi est associé un caisson 38 comprenant les grilles arrière des transistors de sélection 30 appartenant à ce groupe Gi. En d'autres termes, le circuit mémoire 300 comprend un nombre de caissons 38 identique au nombre de groupes Gi. Les transistors appartenant à un même groupe Gi sont réalisés sur le même caisson.

Ainsi, toutes les grilles arrière des transistors de sélection 30 appartenant à un groupe Gi sont soumises au même potentiel de polarisation arrière V_{BB}, ce qui simplifie grandement la conception et la fabrication du circuit mémoire, en particulier du circuit de polarisation.

Lorsqu'une ou plusieurs cellules mémoire sont adressées pour être programmées ou initialisées, leurs transistors de sélection appartenant à un même premier groupe Gi, un potentiel de polarisation arrière directe (FBB) est appliqué (par le circuit de polarisation) au caisson 38 associé à ce premier groupe Gi.

Afin de diminuer la consommation de puissance du circuit mémoire, un potentiel de polarisation arrière inverse (RBB) est avantageusement appliqué au caisson d'un ou plusieurs autres groupes Gi de transistors (dont les cellules mémoire ne sont pas adressées). De préférence, le potentiel de polarisation arrière inverse est appliqué à tous les caissons 38 autres que celui associé aux cellules mémoire adressées.

Dans le mode de réalisation de la figure 4, les caissons 38 associés aux différents groupes Gi sont dopés d'un même type de conductivité (type N ou type P) et espacés les uns des autres. La distance d (mesurée dans la direction des colonnes Ci) qui sépare deux caissons 38 consécutifs est de préférence comprise entre 100 nm et 600 nm, plus préférentiellement supérieure ou égale à 400 nm.

Les transistors de sélection 30 de la matrice sont de préférence tous de type NMOS ou tous de type PMOS. Une bonne homogénéité des performances des cellules mémoire peut être ainsi obtenue.

Afin d'obtenir des transistors de sélection 30 à faible tension de seuil (LVT), les caissons 38 sont avantageusement dopés de type N dans le cas de transistors NMOS et de type P dans le cas de de transistors PMOS.

Dans le mode de réalisation de la figure 5, le circuit mémoire 300 comprend des caissons 38a dopés d'un premier type de conductivité, par exemple de type N, et au moins un caisson 38b dopé d'un deuxième type de conductivité opposé, par exemple de type P. Les caissons 38a dopés du premier type de conductivité et le(s) caisson(s) 38b dopé(s) du deuxième type de conductivité sont disposés en alternance.

Les groupes Gi de transistors sont ainsi répartis en des premiers groupes et des deuxièmes groupes en alternance, les premiers groupes étant associés à des caissons 38a dopés du premier type de conductivité et les deuxième groupes étant associés à des caissons 38b dopés du deuxième type de conductivité. Autrement dit, deux caissons 38a dopés du premier type de conductivité sont séparés par un caisson 38b dopé du deuxième type de conductivité (et inversement à partir de deux caissons 38b).

Comparativement au mode de réalisation de la figure 4, l'espace entre deux caissons du même type de conductivité est utilisé pour disposer un caisson du type de conductivité opposé. Cette disposition permet d'augmenter la densité d'intégration du circuit mémoire 300, car les caissons de type N et de type P sont alors adjacents ou séparés par des premières tranchées d'isolation (tranchées d'isolation profondes). Grâce à ces tranchées d'isolation, il est possible de polariser simultanément un caisson en direct (FBB) et un caisson adjacent (donc de type opposé) en inverse (RBB). En l'absence de tranchées d'isolation entre les caissons, un seul type de polarisation (FBB ou RBB) est possible et les diodes PN formées par les caissons adjacents sont polarisées en inverse. Les premières tranchées d'isolation ont une largeur inférieure à la distance d de la figure 4, et de préférence inférieure à 200 nm.

De préférence, les transistors de sélection 30 partageant un caisson dopé de type N sont des transistors NMOS et les transistors de sélection 30 partageant un caisson dopé de type P sont des transistors PMOS.

Le tableau suivant indique les modes de polarisation arrière (FBB ou RRB) des transistors de sélection 30 du circuit mémoire, selon un mode de mise en oeuvre préférentiel d'un procédé de fonctionnement du circuit mémoire. Le mode de polarisation arrière est donné pour chaque du type d'opération (lecture, initialisation, écriture et effacement) que le procédé de fonctionnement est susceptible de comporter.

**[Tableau 1]**

| | Initialisation | Ecriture (SET) | Effacement (RST) | Lecture |
|---|---|---|---|---|
| caisson sélectionné | FBB | FBB | FBB | RBB |
| caisson non sélectionné | RBB | RBB | RBB | RBB |

Lors d'une initialisation ou d'une programmation (écriture ou effacement) d'une ou plusieurs cellules mémoire, le caisson 38, 38a, 38b associé à ces cellules mémoire (caisson dit « sélectionné ») est polarisé en direct (FBB) et, de préférence, au moins un autre caisson (dit « non sélectionné ») est polarisé en inverse (RBB). Avantageusement, tous les caissons non sélectionnés sont polarisés en inverse (RBB).

Lors d'une lecture d'une ou plusieurs cellules mémoire, le caisson sélectionné est polarisé en inverse (RBB) et, de préférence, au moins un caisson non sélectionné est également polarisé en inverse (RBB). Avantageusement, tous les caissons sont polarisés en inverse (RBB).

De préférence, les groupes Gi comprennent chacun un nombre pair de lignes Li. Dans chaque groupe Gi, les lignes Li sont avantageusement connectées deux par deux pour former une ou plusieurs paires de lignes Li consécutives. Pour chaque paire de lignes Li, les deux transistors de sélection 30 appartenant à une même colonne Ci partagent une même région de source 32. Cet agencement particulier des transistors de sélection 30 augmente encore la densité d'intégration du circuit mémoire 300.

Dans une variante de réalisation non représentée par les figures, les deux transistors de sélection 30 appartenant à une même paire de lignes Li et à une même colonne Ci partagent une même région de drain 33.

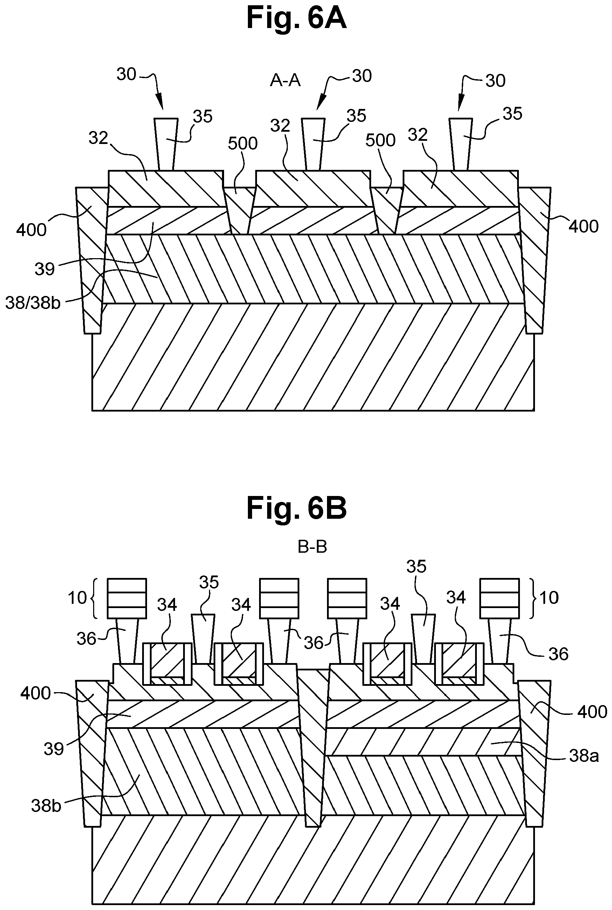

La figure 6A représente une partie du circuit mémoire selon le plan de coupe A-A des figures 4 et 5. Le plan de coupe A-A passe par les électrodes de source 35 des transistors de sélection 30 appartenant à une même ligne Li. Dans chaque groupe Gi, les transistors de sélection 30 appartenant à une même ligne Li et à des colonnes Ci distinctes sont séparés par des deuxièmes tranchées d'isolation 500 appelées tranchées d'isolation peu profondes (technique d'isolation STI, pour « Shallow Trench Isolation » en anglais). Le caisson 38 (ou 38a, 38b selon le cas) associé au groupe Gi est avantageusement entouré par des première tranchées d'isolation 400 (tranchées d'isolation profondes). Les deuxièmes tranchées d'isolation 500 sont moins profondes que les première tranchées d'isolation 400. Elles s'étendent à travers la couche d'oxyde enterrée 39 jusqu'au caisson 38, tandis que les première tranchées d'isolation 400 s'étendent au minimum sur toute la hauteur du caisson 38.

La figure 6B représente une autre partie du circuit mémoire selon le plan de coupe B-B de la figure 5. Contrairement au plan de coupe A-A, le plan de coupe B-B est orienté dans le sens des colonnes Ci. Il passe par les électrodes de source 35 des transistors de sélection 30 appartenant à une même colonne Ci et par les plots de contact 36 des éléments mémoire résistif 10 appartenant à cette même colonne Ci (ces éléments mémoire résistif 10 étant visibles sur la figure).

La figure 6B montre notamment que deux caissons consécutifs 38a-38b, l'un dopé de type N et l'autre dopé de type P, peuvent être séparés par des premières tranchées d'isolation 400 (tranchées d'isolation profondes).

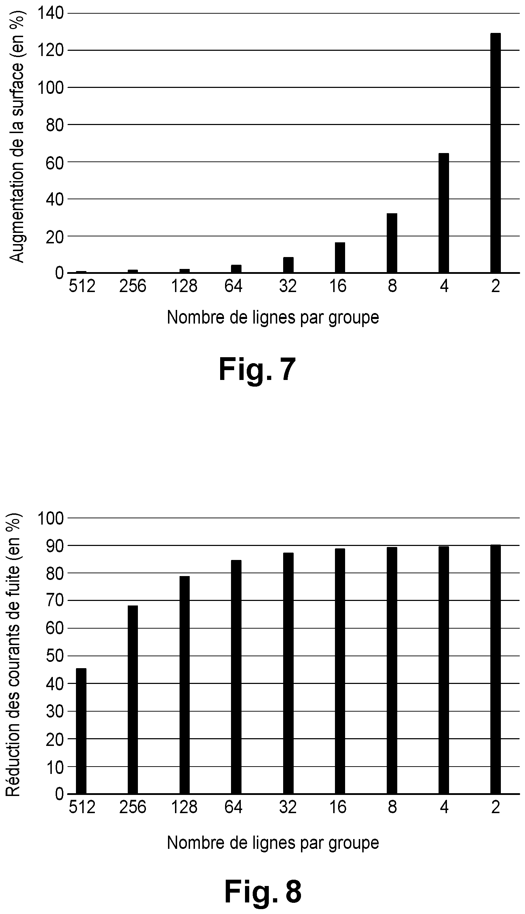

La figure 7 représente l'augmentation de la surface de la matrice mémoire causée par le regroupement des lignes Li de cellules mémoire et la multiplication des caissons, comparativement au cas d'un circuit mémoire dépourvu de caisson ou ne comprenant qu'un seul caisson pour toute la matrice (transistors de sélection NMOS ou PMOS en technologie bulk). L'augmentation de surface est exprimée en pourcentage et représentée en fonction du nombre de lignes par groupe/caisson (un caisson par groupe de lignes).

Plus le nombre de lignes Li par groupe Gi est faible, plus le nombre de caissons est élevé (pour un même nombre de lignes, par exemple 1024 lignes) et plus l'augmentation de surface est importante.

La figure 8 représente, en contrepartie de ce surcoût en surface, la réduction des courants de fuite lors de la lecture d'une cellule mémoire, cette réduction étant obtenue grâce à la polarisation arrière inverse des autres caissons. A nouveau, la réduction des courants de fuite est exprimée en pourcentage et représentée en fonction du nombre de lignes par groupe/caisson.

Plus le nombre de lignes Li par groupe Gi est faible, plus le nombre de lignes Li sous polarisation arrière inverse est élevé et plus la réduction des courants de fuite est importante.

D'après les figures 7 et 8, un bon compromis entre réduction des courants de fuite (et donc baisse de la consommation) et augmentation de la surface de la matrice (perte de densité d'intégration) peut être atteint pour un nombre de lignes Li par groupe Gi compris entre 16 et 256. Par exemple, lorsque les groupes Gi comprennent 64 lignes Li, les courants de fuite sont réduits de 84,38 % pour une augmentation de surface de seulement 3,81 %.

## Revendications

1. Circuit mémoire (300) comprenant une pluralité de cellules mémoire (200), chaque cellule mémoire comprenant un élément mémoire résistif (10) et un transistor de sélection (30) de type FDSOI connecté en série avec l'élément mémoire résistif, le transistor de sélection comprenant une région de canal (31) et une couche isolante enterrée (39), **caractérisé en ce que** le transistor de sélection (30) comprend en outre une grille arrière (38') séparée de la région de canal (31) par la couche isolante enterrée (39), **en ce que** le circuit mémoire (300) comprend en outre un circuit de polarisation de la grille arrière (38') des transistors de sélection (30), le circuit de polarisation étant configuré pour appliquer une polarisation arrière directe au transistor de sélection (30) d'au moins une cellule mémoire (200) lors d'une opération de programmation ou d'initialisation de ladite au moins une cellule mémoire, et **en ce que** :
- les transistors de sélection (30) des cellules mémoire (200) sont agencés en lignes (Li) et en colonnes (Ci) ;
- les lignes (Li) de transistors forment plusieurs groupes (Gi) de transistors, chaque groupe de transistors comprenant au moins deux lignes (Li) de transistors consécutives ;
- le circuit mémoire comprend des régions distinctes de silicium dopé appelées caissons (38), chaque caisson comprenant les grilles arrière (38') des transistors de sélection (30) appartenant à un seul et même groupe de transistors (Gi).

2. Circuit mémoire (300) selon la revendication 1, dans lequel les caissons (38) sont dopés d'un même type de conductivité et espacés les uns des autres.

3. Circuit mémoire (300) selon la revendication 1, comprenant des caissons (38a) dopés d'un premier type de conductivité et au moins un caisson (38b) dopé d'un deuxième type de conductivité opposé, les caissons (38a) dopés du premier type de conductivité et ledit au moins un caisson (38b) dopé du deuxième type de conductivité étant disposés en alternance.

4. Circuit mémoire (300) selon la revendication 3, dans lequel les caissons (38a) dopés du premier type de conductivité et ledit au moins un caisson (38b) dopé du deuxième type de conductivité sont adjacents ou séparés par des tranchées d'isolation électrique.

5. Circuit mémoire (300) selon l'une quelconque des revendications 1 à 4, dans lequel chaque groupe de transistors (Gi) comprend une ou plusieurs paires de lignes de transistors consécutives et dans lequel, pour chaque paire, les transistors de sélection (30) appartenant à une même colonne (Ci) partagent une même région choisie parmi la région de source (32) et la région de drain (33).

6. Circuit mémoire (300) selon l'une quelconque des revendications 1 à 5, dans lequel le circuit de polarisation est configuré pour appliquer un potentiel de polarisation arrière directe (V_{BB}) à un premier caisson (38) lors d'une opération de programmation ou d'initialisation d'une ou plusieurs cellules mémoire (200) dont le transistor de sélection (30) appartient au groupe (Gi) associé au premier caisson.

7. Circuit mémoire (300) selon la revendication 6, dans lequel le circuit de polarisation est en outre configuré pour appliquer un potentiel de polarisation arrière inverse (V_{BB}) à au moins un deuxième caisson (38) distinct du premier caisson.

8. Procédé de fonctionnement d'un circuit mémoire (300) selon l'une quelconque des revendications 1 à 7, le procédé comprenant une opération de programmation ou d'initialisation d'au moins une cellule mémoire, lors de laquelle une polarisation arrière directe est appliquée au transistor de sélection (30) de ladite au moins une cellule mémoire (200).

9. Procédé selon la revendication 8, comprenant en outre une opération de lecture de ladite au moins une cellule mémoire (200), lors de laquelle une polarisation arrière inverse est appliquée au transistor de sélection (30) de ladite au moins une cellule mémoire (200).

10. Procédé selon l'une des revendications 8 et 9, comprenant en outre l'application d'une polarisation arrière inverse aux transistors de sélection (30) des cellules mémoire (200) en dehors des opérations de programmation, d'initialisation et de lecture des cellules mémoire.

## Patentansprüche

1. Speicherschaltung (300) mit einer Vielzahl von Speicherzellen (200), wobei jede Speicherzelle ein resistives Speicherelement (10) und einen Auswahltransistor (30) vom FDSOI-Typ umfasst, der mit dem resistiven Speicherelement in Reihe geschaltet ist, wobei der Auswahltransistor einen Kanalbereich (31) und eine verdeckte Isolierschicht (39) umfasst, **dadurch gekennzeichnet, dass** der Auswahltransistor (30) ferner ein rückwärtiges Gate (38') umfasst, das von dem Kanalbereich (31) durch die verdeckte Isolierschicht (39) getrennt ist, und dadurch, dass die Speicherschaltung (300) ferner eine Schaltung zum Vorspannen des rückwärtigen Gates (38') der Auswahltransistoren (30) umfasst, wobei die Vorspannungsschaltung so konfiguriert ist, dass sie während eines Programmier- oder Initialisierungsvorgangs der mindestens einen Speicherzelle (200) eine direkte rückwärtige Vorspannung an den Auswahltransistor (30) der mindestens einen Speicherzelle (200) anlegt, und dadurch dass:
- die Auswahltransistoren (30) der Speicherzellen (200) in Zeilen (Li) und Spalten (Ci) angeordnet sind;
- die Transistorzeilen (Li) mehrere Transistorgruppen (Gi) bilden, wobei jede Transistorgruppe mindestens zwei aufeinanderfolgende Transistorzeilen (Li) umfasst;
- die Speicherschaltung getrennte Bereiche aus dotiertem Silizium umfasst, die als Wannen (38) bezeichnet werden, wobei jede Wanne die rückwärtigen Gates (38') der Auswahltransistoren (30) umfasst, die zu ein und derselben Transistorgruppe (Gi) gehören.

2. Speicherschaltung (300) nach Anspruch 1, in der die Wannen (38) mit einem gleichen Leitfähigkeitstyp dotiert und voneinander beabstandet sind.

3. Speicherschaltung (300) nach Anspruch 1, mit Wannen (38a), die mit einem ersten Leitfähigkeitstyp dotiert sind, und mindestens einer Wanne (38b), die mit einem zweiten, entgegengesetzten Leitfähigkeitstyp dotiert ist, wobei die Wannen (38a), die mit dem ersten Leitfähigkeitstyp dotiert sind, und die mindestens eine Wanne (38b), die mit dem zweiten Leitfähigkeitstyp dotiert ist, abwechselnd angeordnet sind.

4. Speicherschaltung (300) nach Anspruch 3, in der die dotierten Wannen (38a) des ersten Leitfähigkeitstyps und die mindestens eine dotierte Wanne (38b) des zweiten Leitfähigkeitstyps aneinander angrenzen oder durch elektrisch isolierende Gräben voneinander getrennt sind.

5. Speicherschaltung (300) nach einem der Ansprüche 1 bis 4, in der jede Transistorgruppe (Gi) ein oder mehrere Paare von aufeinanderfolgenden Transistorzeilen umfasst und in der für jedes Paar die Auswahltransistoren (30), die zu einer gleichen Spalte (Ci) gehören, einen gleichen Bereich teilen, der aus dem Source-Bereich (32) und dem Drain-Bereich (33) ausgewählt ist.

6. Speicherschaltung (300) nach einem der Ansprüche 1 bis 5, in der die Vorspannungsschaltung so konfiguriert ist, dass sie bei einem Programmier- oder Initialisierungsvorgang einer oder mehrerer Speicherzellen (200), deren Auswahltransistor (30) zu der der ersten Wanne zugeordneten Gruppe (Gi) gehört, ein direktes rückwärtiges Vorspannungspotenzial (V_{BB}) an eine erste Wanne (38) anlegt.

7. Speicherschaltung (300) nach Anspruch 6, in der die Vorspannungsschaltung ferner so konfiguriert ist, dass sie ein umgekehrtes rückwärtiges Vorspannungspotenzial (V_{BB}) an mindestens eine zweite Wanne (38) anlegt, die sich von der ersten Wanne unterscheidet.

8. Verfahren zum Betreiben einer Speicherschaltung (300) nach einem der Ansprüche 1 bis 7, wobei das Verfahren einen Programmier- oder Initialisierungsvorgang von mindestens einer Speicherzelle umfasst, bei dem eine direkte rückwärtige Vorspannung an den Auswahltransistor (30) der mindestens einen Speicherzelle (200) angelegt wird.

9. Verfahren nach Anspruch 8, das weiterhin einen Lesevorgang der mindestens einen Speicherzelle (200) umfasst, bei dem eine umgekehrte rückwärtige Vorspannung an den Auswahltransistor (30) der mindestens einen Speicherzelle (200) angelegt wird.

10. Verfahren nach einem der Ansprüche 8 und 9, das außerdem das Anlegen einer umgekehrten rückwärtigen Vorspannung an die Auswahltransistoren (30) der Speicherzellen (200) außerhalb der Programmier-, Initialisierungs- und Lesevorgänge der Speicherzellen umfasst.

## Claims

1. Memory circuit (300) comprising a plurality of memory cells (200), each memory cell comprising a resistive memory element (10) and a selection transistor (30) of the FDSOI type connected in series with the resistive memory element, the selection transistor comprising a channel region (31) and a buried insulating layer (39), **characterised in that** the selection transistor (30) further comprises a back gate (38') separated from the channel region (31) by the buried insulating layer (39), **in that** the memory circuit (300) further comprises a circuit for biasing the back gate (38') of the selection transistors (30), the biasing circuit being configured to apply a forward back-bias to the selection transistor (30) of at least one memory cell (200) during a programming or initialisation operation of said at least one memory cell, and **in that**:
- the selection transistors (30) of the memory cells (200) are arranged in lines (Li) and in columns (Ci);
- the lines (Li) of transistors form several groups (Gi) of transistors, each group of transistors comprising at least two lines (Li) of consecutive transistors;
- the memory circuit comprises distinct regions of doped silicon called wells (38), each well comprising the back gates (38') of the selection transistors (30) belonging to a single and same group of transistors (Gi).

2. Memory circuit (300) according to claim 1, wherein the wells (38) are doped with the same type of conductivity and spaced apart from one another.

3. Memory circuit (300) according to claim 1, comprising wells (38a) doped with a first type of conductivity and at least one well (38b) doped with a second opposite type of conductivity, the wells (38a) doped with the first type of conductivity and said at least one well (38b) doped with the second type of conductivity being disposed alternately.

4. Memory circuit (300) according to claim 3, wherein the wells (38a) doped with the first type of conductivity and said at least one well (38b) doped with the second type of conductivity are adjacent or separated by electrical isolation trenches.

5. Memory circuit (300) according to any of claims 1 to 4, wherein each group of transistors (Gi) comprises one or more pairs of consecutive lines of transistors and wherein, for each pair, the selection transistors (30) that belong to the same column (Ci) share a same region chosen from the source region (32) and the drain region (33).

6. Memory circuit (300) according to any of claims 1 to 5, wherein the biasing circuit is configured to apply a forward back-bias potential (V_{BB}) to a first well (38) during a programming or initialisation operation of one or more memory cells (200) the selection transistor (30) of which belongs to the group (Gi) associated with the first well.

7. Memory circuit (300) according to claim 6, wherein the biasing circuit is furthermore configured to apply a reverse back-bias potential (V_{BB}) to at least one second well (38) distinct from the first well.

8. Method of operation of a memory circuit (300) according to any of claims 1 to 7, the method comprising a programming or initialisation operation of at least one memory cell, during which a forward back-bias is applied to the selection transistor (30) of said at least one memory cell (200).

9. Method according to claim 8, further comprising a read operation of said at least one memory cell (200), during which a reverse back-bias is applied to the selection transistor (30) of said at least one memory cell (200).

10. Method according to one of claims 8 and 9, further comprising the application of a reverse back-bias to the selection transistors (30) of the memory cells (200) outside the programming, initialisation and read operations of the memory cells.
